# EUROPEAN PATENT SPECIFICATION

(11) **EP 4 467 998 B1**
(45) Date of publication and mention of the grant of the patent: **25.11.2026**
(21) Application number: 23749974.4
(22) Date of filing: 03.02.2023
(51) Int. Cl.: G01R 31/367, G01R 31/396, G01R 31/382, G06N 20/00, G01R 31/3842, G06N 3/045, G06N 3/08

(54) **BATTERY SOC ESTIMATION METHOD AND DEVICE BASED ON META-LEARNING**
VERFAHREN UND VORRICHTUNG ZUR SCHÄTZUNG DES LADEZUSTANDS EINER BATTERIE AUF BASIS VON METALERNEN
PROCÉDÉ ET DISPOSITIF D'ESTIMATION D'ÉTAT DE CHARGE D'UNE BATTERIE BASÉS SUR UN MÉTA-APPRENTISSAGE

(30) Priority: 04.02.2022 KR 20220014533
(43) Date of publication of application: 27.11.2024
(73) Proprietor: IUCF-HYU (INDUSTRY-UNIVERSITY COOPERATION FOUNDATION HANYANG UNIVERSITY), Seoul 04763 (KR)
(72) Inventor: BAE, Sung Woo, Seoul 04763 (KR); JEONG, Dae Ung, Seoul 04763 (KR)
(74) Representative: Prüfer & Partner mbB Patentanwälte · Rechtsanwälte
(86) International application number: PCT/KR2023/001565
(87) International publication number: WO 2023/149741

(56) References cited:
- KR-A- 20190 100 114
- KR-A- 20200 063 330
- KR-A- 20210 023 641
- KR-A- 20210 121 411
- KR-B1- 100 793 616
- KR-B1- 100 793 616

## Description

### [Technical Field]

The present invention relates to a method and device for estimating a battery state of charge (SOC), and more particularly, to a device and method for estimating a battery SOC on the basis of meta-learning.

### [Background Art]

Implementing an algorithm for estimating a battery state of charge (SOC) using a deep learning model requires a large amount of charge and discharge data of a target battery. Acquiring a large amount of battery charge and discharge data is a necessary preceding process for training a deep learning model, which is costly and time-consuming. Accordingly, this is pointed out as a major drawback of deep learning model-based battery state estimation methods. Also, when a type of target battery changes, it is necessary to collect training data from the beginning to retrain the deep learning model. This is a costly and time-consuming disadvantage for battery management system (BMS) development in applications where vehicle types can vary such as electric vehicles.

Transfer learning was proposed to solve the problem of obtaining training data for training deep learning models. Transfer learning is a method of applying an already trained deep learning model to another model, reducing the amount of data required for training by applying results of the already trained deep learning model rather than training the other model from the beginning. When transfer learning is applied to battery SOC estimation, it is possible to train SOC estimation for a target battery on the basis of information on another battery for which training was performed in advance. However, since transfer learning is performed on the basis of preceding training data for a single battery, the SOC estimation performance of a deep learning model based on transfer learning is mainly determined by the similarity between pretraining battery data and target battery data.

An equivalent model-based battery SOC estimation method involves, for the development of a new BMS, a process of identifying a battery open-circuit voltage (OCV)-SOC relationship through a battery characteristic test and constructing a lookup table, and requires a battery characteristic test to determine a modeling factor, such as battery internal resistance, that is necessary to construct a battery equivalent model. KR 100 793 616 B1 is related to an apparatus for estimating a remaining amount of a battery, comprising: a sensing unit for sensing current, voltage and temperature of the battery cell; and a soft computing unit for outputting a battery remaining amount estimation value for processing the current, voltage, and temperature detected by the sensing unit by a radiation function according to a neural network algorithm, wherein a parameter of the neural network algorithm is adaptively updated by combining any one of a fuzzy algorithm, a genetic algorithm, a cellular auto-meta algorithm, an immune system algorithm or a rough-set algorithm.

### [Disclosure]

### [Technical Problem]

The present invention is directed to providing a meta-learning-based battery state of charge (SOC) estimation method and device for accurately estimating a battery SOC using less training data.

The present invention is also directed to providing a meta-learning-based battery SOC estimation method and device for accurately estimating an SOC of a target battery without being significantly affected by the similarity of charge and discharge data between a training battery and a target battery.

### [Technical Solution]

One embodiment of the present invention to achieve the above objects provides a battery state of charge (SOC) estimation method including collecting training data for a plurality of reference batteries, performing meta-learning of a global SOC estimation model for estimating an SOC value of a target battery using first training parameters of local SOC estimation models which are for the reference batteries and trained using the training data, and estimating an SOC value of the target battery using the global SOC estimation model of which the meta-learning has been performed.

Another embodiment of the present invention to achieve the above objects provides a battery SOC estimation method including receiving a global SOC estimation model for estimating an SOC value of a target battery, training the global SOC estimation model using training data for the target battery to tune first training parameters of the global SOC estimation model, and estimating an SOC value of the target battery using the global SOC estimation model of which the first training parameters have been tuned. The global SOC estimation model is an estimation model of which meta-learning has been performed using second training parameters of local SOC estimation models that are for a plurality of reference batteries and trained using training data for the reference batteries.

Still another embodiment of the present invention to achieve the above objects provides a battery SOC estimation device including a memory and at least one processor electrically connected to the memory. The processor performs meta-learning of a global SOC estimation model using first training parameters of local SOC estimation models, which are for a plurality of reference batteries and trained using training data for the reference batteries, and estimates an SOC value of a target battery using the global SOC estimation model of which the meta-learning has been performed.

### [Advantageous Effects]

According to an embodiment of the present invention, training parameters of a global state of charge (SOC) estimation model for a target battery are first determined through meta-learning, and thus the training parameters of the global SOC estimation model can be effectively tuned using a small amount of training data for the target battery.

In addition, according to an embodiment of the present invention, charge and discharge data of various kinds of reference batteries is used for training, and thus it is possible to solve the problem of transfer learning that SOC estimation performance is significantly affected by the similarity of charge and discharge data.

### [Description of Drawings]

FIG. 1 is a flowchart illustrating a battery state of charge (SOC) estimation method according to an embodiment of the present invention.
FIG. 2 is a flowchart illustrating a battery SOC estimation method according to another embodiment of the present invention.
FIG. 3 is a flowchart illustrating a battery SOC estimation method according to still another embodiment of the present invention.
FIG. 4 is a diagram illustrating an battery SOC estimation device according to an embodiment of the present invention.

### [Modes of the Invention]

The present invention may be modified into various forms and may have a variety of embodiments, and specific embodiments will be illustrated in the accompanying drawings and described in detail below. However, this is not intended to limit the present invention to a specific embodiment, and it should be understood to include all changes, or substitutes included in the scope of the present invention. In describing each drawing, like reference numerals are used for like components.

A battery state of charge (SOC) estimation method based on a deep learning model facilitates implementation of a deep learning SOC estimation model even without theoretical preliminary knowledge. Also, since a battery SOC may be estimated on the basis of data measured by a battery management system (BMS), the battery SOC estimation method is easily applied to an energy storage system (ESS) and the like that is required for large-scale battery management.

However, according to a battery SOC estimation method based on a deep learning model and a battery SOC estimation method based on transfer learning, the above-described problems may occur. The present invention proposes a meta-learning-based battery SOC estimation method for solving the problems.

In other words, the present invention proposes a battery SOC estimation method to train a deep learning model for battery SOC estimation using a small amount of training data and accurately estimate an SOC of a target battery without being significantly affected by the similarity of charge and discharge data between a training battery and the target battery.

A battery SOC estimation method according to an embodiment of the present invention may be performed in a computing device including a memory and a processor.

Hereinafter, embodiments of the present invention will be described in detail with reference to the accompanying drawings.

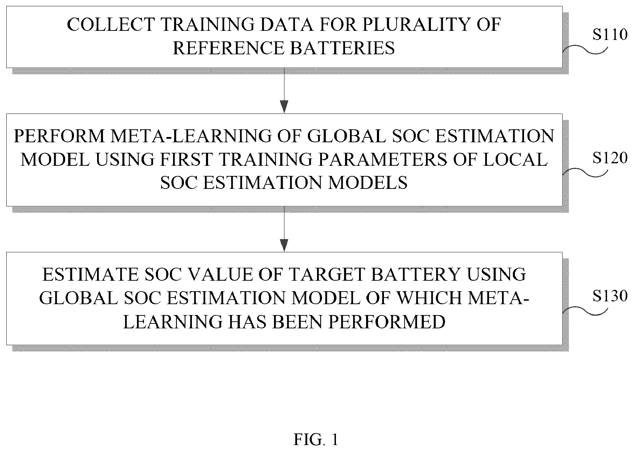

FIG. 1 is a flowchart illustrating a battery SOC estimation method according to an embodiment of the present invention.

Referring to FIG. 1, a computing device according to an embodiment of the present invention collects training data for a plurality of reference batteries (S110). The reference batteries are training batteries used to acquire training data and may be batteries that differ in at least one of chemical structure and battery capacity. Here, batteries that differ in chemical structure are batteries with different elements contained therein. For example, among lithium-ion batteries, a battery with anode materials of nickel, cobalt, and manganese and a battery with anode materials of phosphoric acid and iron have different chemical structures.

Training data is charge and discharge data of batteries and includes voltages, currents, temperatures, and SOC values measured during charge and discharge of the batteries. Training data may be obtained from a BMS of batteries. Training data for the reference batteries includes voltages, currents, temperatures, and SOC values measured during charge and discharge of training batteries. SOC values may be labeled with ground-truth values of voltages, currents, and temperatures.

The computing device performs meta-learning of a global SOC estimation model for estimating an SOC value of a target battery using first training parameters of a local SOC estimation model for each of the reference batteries (S120). The computing device determines second training parameters of the global SOC estimation model using meta-learning. Training parameters may be weights of an SOC estimation model.

Each of local SOC estimation models is a model that is trained using training data for each of the reference batteries to estimate an SOC of the reference battery. For example, a first local SOC estimation model is trained using training data for a first reference battery to estimate an SOC of the first reference battery, and a second local SOC estimation model is trained using training data for a second reference battery to estimate an SOC of the second reference battery.

The target battery may be a battery that differs in at least one of chemical structure and battery capacity from the reference battery.

Local and global SOC estimation models may be various deep learning models and may be artificial neural networks such as a convolutional neural network (CNN), a deep neural network (DNN), a recurrent neural network (RNN), and the like.

In operation S120, the computing device determines second training parameters of the global SOC estimation model from first training parameters of the local SOC estimation models. According to an embodiment, the computing device may determine that first training parameters for minimizing the sum of loss values of the local SOC estimation models are second training parameters. In other words, the second training parameters may correspond to training parameters for minimizing the sum of loss values of the local SOC estimation models when the second training parameters are applied to the local SOC estimation models.

Unlike transfer learning, when charge and discharge data of various kinds of reference batteries is used for training, it is possible to solve the problem of transfer learning that SOC estimation performance is significantly affected by the similarity of charge and discharge data according to an embodiment of the present invention.

The computing device estimates an SOC value of the target battery using the global SOC estimation model of which meta-learning has been performed (S130). When charge and discharge data of the target battery corresponding to the training data is input to the global SOC estimation model, the global SOC estimation model outputs an SOC value of the target battery corresponding to the input charge and discharge data.

Here, to improve SOC estimation accuracy of the target battery, the computing device may tune the second training parameters of the global SOC estimation model. The computing device trains the global SOC estimation model using training data for the target battery to tune the second training parameters. In other words, the computing device retrains the global SOC estimation model, of which the second training parameters have been determined through meta-learning, using the training data for the target battery to tune the second training parameters. Also, the global SOC estimation model, of which the second training parameters have been tuned, is utilized to estimate an SOC value of the target battery.

The training data for the target battery may be of the same type as training data for the reference battery, but the amount of the training data for the target battery may be smaller than that of the training data for the reference battery. In other words, the training data for the target battery may include voltages, currents, temperatures, and SOC values measured during charge and discharge of the target battery like the training data for the reference battery, but may be data acquired from a part of the full range from a discharged state of the target battery to a fully charged state rather than the full range.

Since the second training parameters of the global SOC estimation model are first determined through the meta-learning process, the second training parameters may be effectively tuned such that SOC estimation performance for the target battery can be improved using only a small amount of training data for the target battery.

Consequently, according to an embodiment of the present invention, it is possible to not only estimate an SOC of a battery without performance degradation using a smaller amount of training data than is required when a general deep learning SOC estimation model is used, but also reduce a time required for training because a small amount of training data is used.

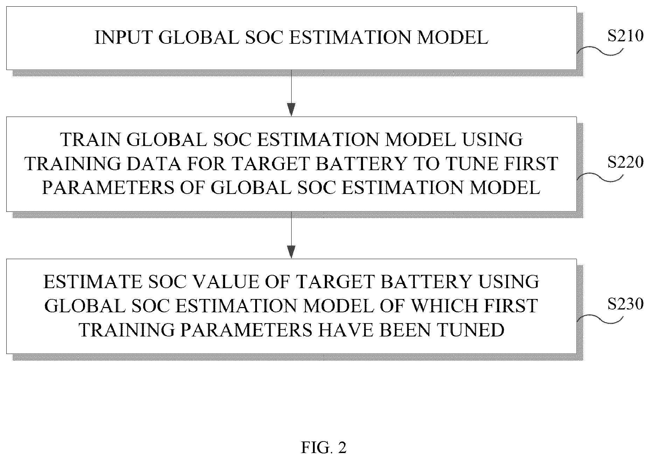

FIG. 2 is a flowchart illustrating a battery SOC estimation method according to another embodiment of the present invention.

Unlike the embodiment of FIG. 1, in the embodiment of FIG. 2, training of a local SOC estimation model is performed not in a computing device that estimates a battery SOC but in an additional computing device. A local SOC estimation model trained in the additional computing device is input to the computing device that estimates a battery SOC.

Referring to FIG. 2, the computing device according to an embodiment of the present invention receives a global SOC estimation model for estimating an SOC value of a target battery (S210). The computing device trains the global SOC estimation model using training data for a target battery to tune second training parameters of the global SOC estimation model (S220). Then, the computing device utilizes the global SOC estimation model of which the second training parameters have been tuned, to estimate an SOC value of the target battery (S230).

The global SOC estimation model is an estimation model of which meta-learning has been performed using first training parameters of a local SOC estimation model for each reference battery, and local SOC estimation models are trained using training data for a plurality of reference batteries.

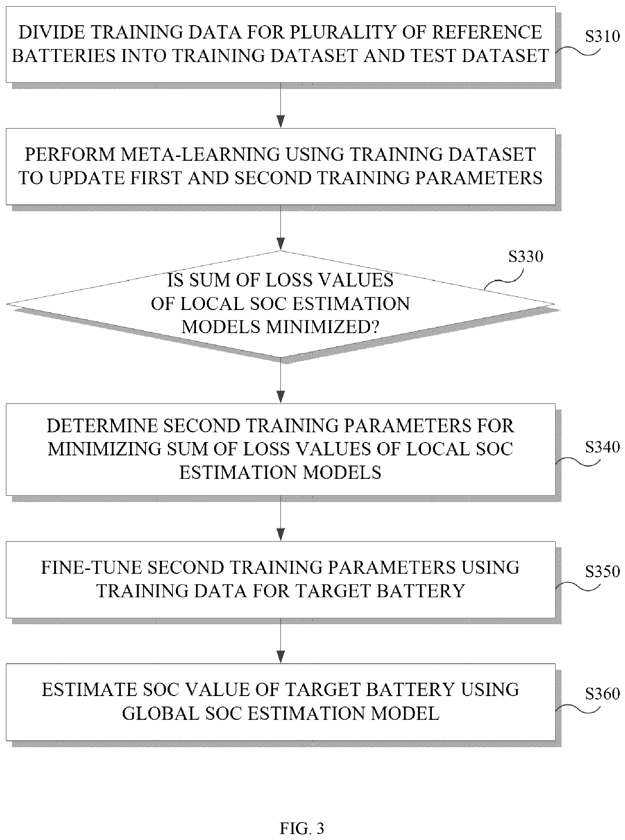

FIG. 3 is a flowchart illustrating a battery SOC estimation method according to still another embodiment of the present invention.

Referring to FIG. 3, a computing device according to an embodiment of the present invention divides training data for a plurality of reference batteries into a training dataset ${D}_{i}^{pre - train}$ and a test dataset ${D}_{i}^{test}$ (S310). Then, the computing device performs meta-learning using the training dataset to update first training parameters of local SOC estimation models and second training parameters of a global SOC estimation model (S320).

The local SOC estimation models separately correspond to reference batteries. In other words, when N reference batteries are used, N local SOC estimation models are used.

An update process of first training parameters may be expressed as shown in Equation 1. The computing device may perform training to minimize a loss value of an SOC estimation model using gradient descent such as stochastic gradient descent (SGD), momentum, adaptive movement estimation (Adam), or the like. [Equation 1] ${{Φ}^{′}}_{i} = {θ}_{meta} - α {∇}_{{θ}_{meta}} {L}_{i} \left({θ}_{meta}, {D}_{i}^{pre - train}\right)$

Here, *Φ́ᵢ* is an updated first training parameter, *θₘₑₜₐ* is an updated second training parameter, Lᵢ is a loss function of a local SOC estimation model, α is a learning rate, and i is an index of the local SOC estimation model.

Through the meta-learning, the second training parameters are updated in a direction in which the sum of loss values of loss functions of the local SOC estimation models is minimized, and the second training parameters may be updated to satisfy Equation 2. [Equation 2] $\begin{matrix}{min}_{{{θ}^{′}}_{meta}} = {\sum }_{i} {L}_{i} \left({θ}_{meta}, {D}_{i}^{pre - train}\right) \\ = {\sum }_{i} {L}_{i} \left({θ}_{meta}-α{∇}_{{θ}_{meta}}L\left({θ}_{meta}, {D}_{i}^{pre - train}\right)\right)\end{matrix}$

The computing device calculates the sum of loss values of the local SOC estimation models using the test dataset as shown in Equation 3 and determines whether the calculated value is minimized (S330). When the calculated value is not minimized, operation S320 is performed. When the calculated value is not minimized, first training parameters of this case are determined as second training parameters (S340). In other words, when the determined second training parameters are input to the local SOC estimation models, the sum of loss values of the local SOC estimation models may be minimized. [Equation 3] ${{θ}^{′}}_{meta} = {θ}_{meta} - β {∇}_{{θ}_{meta}} {\sum }_{i} {L}_{i} \left({{θ}^{′}}_{i}, {D}_{i}^{test}\right)$

Here, *θ́ₘₑₜₐ* is a second training parameter determined through meta-learning, and β is a step size for determining a second training parameter.

The computing device fine-tunes the second training parameters of the global SOC estimation model using training data for a target battery (S350). The computing device may fine-tune the second training parameters using Equation 4. [Equation 4] ${{Φ}^{′}}_{target} = {{θ}^{′}}_{meta} - γ {∇}_{{θ}_{meta}} {L}_{f} \left({{θ}^{′}}_{meta}, {D}_{target}\right)$

Here, *Φ́_{target}* is a fine-tuned second training parameter, *γ* is a step size applied during a fine-tuning process, D_{target} is training data for a target battery, and L_{f} is a loss function of the global SOC estimation model for fine tuning.

The loss function of the global SOC estimation model may be calculated as the mean square error between an estimated SOC value and a ground truth SOC value as shown in Equation 5. [Equation 5] ${L}_{f} = \frac{1}{2} {\sum }_{i} {\left({SOC}_{true}-{SOC}_{est}\right)}^{2}$

Here, SOCₜᵣᵤₑ is a ground truth SOC value of training data, and SOCₑₛₜ is an SOC value estimated by the global SOC estimation model.

The computing device estimates an SOC value of the target battery using the global SOC estimation model of which the second training parameters have been fine-tuned (S360). The computing device may acquire an SOC value Y by inputting real-time charge and discharge data of the target battery to the global SOC estimation model, and the SOC value Y may be expressed as shown in Equation 6. [Equation 6] $Y = α \left({{Φ}^{′}}_{target}X+b\right)$

Here, a is an activation function, X is charge and discharge data of the target battery, and b is a bias value.

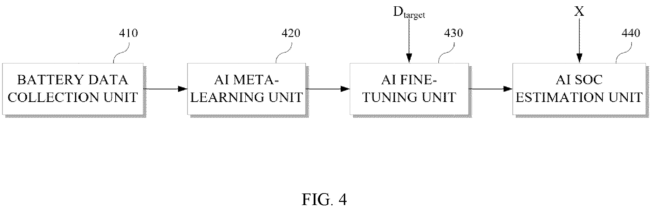

FIG. 4 is a diagram illustrating an battery SOC estimation device according to an embodiment of the present invention.

Referring to FIG. 4, the battery SOC estimation device according to the embodiment of the present invention includes a battery data collection unit 410, an artificial intelligence (AI) meta-learning unit 420, an AI fine-tuning unit 430, and an AI SOC estimation unit 440.

The battery data collection unit 410 collects training data for a reference battery.

The AI meta-learning unit 420 performs meta-learning on the collected training data and determines training parameters of a global SOC estimation model.

The AI fine-tuning unit 430 fine-tunes the training parameters of a global SOC estimation model using training data D_{target} for a target battery.

The AI SOC estimation unit 440 estimates an SOC value of the target battery using charge and discharge data X of the target battery and the global SOC estimation model of which the training parameters have been fine-tuned.

Meanwhile, an SOC estimation device according to another embodiment of the present invention may include a memory and at least one processor electrically connected to the memory. The processor may perform meta-learning of a global SOC estimation model using first training parameters of local SOC estimation models, which are for a plurality of reference batteries and trained using training data for the reference batteries, and estimate an SOC value of a target battery using the global SOC estimation model of which meta-learning has been performed.

The processor may determine second training parameters of the global SOC estimation model, train the global SOC estimation model using training data for the target battery, and tune the second training parameters of the global SOC estimation model.

The above-described technical content may be implemented in the form of a program command executable by various computing means and recorded on a computer-readable recording medium. The computer-readable recording medium may include program commands, data files, data structures, and the like individually or in combination. The program commands recorded on the medium may be specially designed and configured for embodiments or may be known and available to those of ordinary skill in the computer software field. Examples of the computer-readable recording medium include magnetic media such as a hard disk, a floppy disk, and magnetic tape, optical media such as a compact disc read-only memory (CD-ROM) and a digital versatile disc (DVD), magneto-optical media such as a floptical disk, and hardware devices such as a ROM, a random access memory (RAM), a flash memory, and the like for storing and executing program commands. Examples of the program commands include a machine language code created by a compiler and a high-level language code executable by a computer through an interpreter and the like. The hardware devices may be configured to operate as one or more software modules to perform operations of the embodiments, and vice versa.

While the present invention has been described above with reference to specific details, such as specific components, and limited embodiments and drawings, these are only provided to aid in overall understanding of the present invention and can be diversely modified and altered by those of ordinary skill in the art. Therefore, the scope of the present invention should not be limited to the above-described embodiments, and in addition to the following claims, all modifications fall within the scope of the present invention.

## Claims

1. A battery state of charge (SOC) estimation method comprising:
collecting training data (S110) for a plurality of reference batteries;
performing meta-learning of a global SOC estimation model (S120) for estimating an SOC value of a target battery using first training parameters of local SOC estimation models which are for the plurality of reference batteries and trained using the training data; and
estimating an SOC value of the target battery (S130) using the global SOC estimation model of which the meta-learning has been performed.

2. The battery SOC estimation method of claim 1, wherein the training data includes voltages, currents, temperatures, and SOC values measured during charge and discharge of the plurality of reference batteries.

3. The battery SOC estimation method of claim 1, wherein the performing of the meta-learning comprises determining second training parameters of the global SOC estimation model, and
when the second training parameters are applied to the local SOC estimation models, a sum of loss values of the local SOC estimation models is minimized.

4. The battery SOC estimation method of claim 3, wherein the estimating of the SOC value of the target battery comprises:
training the global SOC estimation model using training data for the target battery to tune the second training parameters; and
estimating an SOC value of the target battery using the global SOC estimation model of which the second training parameters have been tuned.

5. The battery SOC estimation method of claim 4, wherein the training data for the target battery is of the same type as training data for the plurality of reference batteries, and
an amount of the training data for the target battery is smaller than an amount of the training data for the plurality of reference batteries.

6. The battery SOC estimation method of claim 5, wherein the amount of the training data for the target battery is acquired from a part of a full range from a discharged state of the target battery to a fully charged state.

7. The battery SOC estimation method of claim 1, wherein the target battery is a battery that differs in at least one of chemical structure and battery capacity from the plurality of reference batteries.

8. The battery SOC estimation method of claim 1, wherein the plurality of reference batteries are batteries that differ in at least one of chemical structure and battery capacity from each other.

9. A battery state of charge (SOC) estimation method comprising:
receiving a global SOC estimation model (S210) for estimating an SOC value of a target battery;
training the global SOC estimation model (S220) using training data for the target battery to tune first training parameters of the global SOC estimation model; and estimating an SOC value of the target battery (S230) using the global SOC estimation model of which the first training parameters have been tuned,
wherein the global SOC estimation model is an estimation model of which meta-learning has been performed using second training parameters of local SOC estimation models that are for a plurality of reference batteries and trained using training data for the reference batteries.

10. The battery SOC estimation method of claim 9, wherein, when the first training parameters are applied to the local SOC estimation models, a sum of loss values of the local SOC estimation models is minimized.

11. A battery state of charge (SOC) estimation device (440) comprising:
a memory; and
at least one processor electrically connected to the memory,
wherein the processor is configured to perform meta-learning of a global SOC estimation model using first training parameters of local SOC estimation models, which are for a plurality of reference batteries and trained using training data for the plurality of reference batteries, and is configured to estimate an SOC value of a target battery using the global SOC estimation model of which the meta-learning has been performed.

12. The battery SOC estimation device of claim 11, wherein the processor is configured to determine second training parameters of the global SOC estimation model, and
when the second training parameters are applied to the local SOC estimation models, a sum of loss values of the local SOC estimation models is minimized.

13. The battery SOC estimation device of claim 11, wherein the processor is configured to train the global SOC estimation model using training data acquired from the target battery to update meta-learning parameters of the global SOC estimation model and is configured to estimate an SOC value of the target battery using the updated global SOC estimation model.

## Patentansprüche

1. Verfahren zur Abschätzung des Ladezustands (state of charge, SOC) einer Batterie, umfassend:
Erfassen von Trainingsdaten (S110) für eine Mehrzahl von Referenzbatterien;
Durchführen eines Meta-Lernens eines globalen SOC-Schätzmodells (S120) zur Abschätzung eines SOC-Werts einer Zielbatterie unter Verwendung erster Trainingsparameter lokaler SOC-Schätzmodelle, die für die Mehrzahl von Referenzbatterien sind und unter Verwendung der Trainingsdaten trainiert wurden; und
Abschätzung eines SOC-Werts der Zielbatterie (S130) unter Verwendung des globalen SOC-Schätzmodells, für das das Meta-Lernen durchgeführt wurde.

2. Verfahren zur SOC-Abschätzung einer Batterie nach Anspruch 1, wobei die Trainingsdaten Spannungen, Ströme, Temperaturen und SOC-Werte umfassen, die während dem Laden und Entladen der Mehrzahl von Referenzbatterien gemessen wurden.

3. Verfahren zur SOC-Abschätzung einer Batterie nach Anspruch 1, wobei die Durchführung des Meta-Lernens das Bestimmen zweiter Trainingsparameter des globalen SOC-Schätzmodells umfasst, und
wenn die zweiten Trainingsparameter auf die lokalen SOC-Schätzmodelle angewendet werden, eine Summe von Verlustwerten der lokalen SOC-Schätzmodelle minimiert wird.

4. Verfahren zur SOC-Abschätzung einer Batterie nach Anspruch 3, wobei die Abschätzung des SOC-Werts der Zielbatterie umfasst:
Trainieren des globalen SOC-Schätzmodells unter Verwendung von Trainingsdaten für die Zielbatterie, um die zweiten Trainingsparameter abzustimmen; und
Abschätzen eines SOC-Werts der Zielbatterie unter Verwendung des globalen SOC-Schätzmodells, dessen zweite Trainingsparameter abgestimmt wurden.

5. Verfahren zur SOC-Abschätzung einer Batterie nach Anspruch 4, wobei die Trainingsdaten für die Zielbatterie vom gleichen Typ sind wie die Trainingsdaten für die Mehrzahl der Referenzbatterien, und
eine Menge der Trainingsdaten für die Zielbatterie kleiner ist als eine Menge der Trainingsdaten für die Mehrzahl der Referenzbatterien.

6. Verfahren zur SOC-Abschätzung einer Batterie nach Anspruch 5, wobei die Menge der Trainingsdaten für die Zielbatterie aus einem Teil des gesamten Bereichs von einem entladenen Zustand der Zielbatterie bis zu einem vollständig geladenen Zustand gewonnen wird.

7. Verfahren zur SOC-Abschätzung einer Batterie nach Anspruch 1, wobei die Zielbatterie eine Batterie ist, die sich in der chemischen Struktur und/oder Batteriekapazität von der Mehrzahl der Referenzbatterien unterscheidet.

8. Verfahren zur SOC-Abschätzung einer Batterie nach Anspruch 1, wobei die Mehrzahl der Referenzbatterien Batterien sind, die sich in der chemischen Struktur und/oder Batteriekapazität voneinander unterscheiden.

9. Verfahren zur Abschätzung des Ladezustands (state of charge, SOC) einer Batterie, umfassend:
Empfangen eines globalen SOC-Schätzmodells (S210) zur Abschätzung eines SOC-Werts einer Zielbatterie;
Trainieren des globalen SOC-Schätzmodells (S220) unter Verwendung von Trainingsdaten für die Zielbatterie, um erste Trainingsparameter des globalen SOC-Schätzmodells abzustimmen; und
Abschätzen eines SOC-Werts der Zielbatterie (S230) unter Verwendung des globalen SOC-Schätzmodells, dessen erste Trainingsparameter abgestimmt wurden,
wobei das globale SOC-Schätzmodell ein Schätzmodell ist, für das ein Meta-Lernen unter Verwendung zweiter Trainingsparameter lokaler SOC-Schätzmodelle durchgeführt wurde, die für eine Mehrzahl von Referenzbatterien sind und unter Verwendung von Trainingsdaten für die Referenzbatterien trainiert wurden.

10. Verfahren zur SOC-Abschätzung einer Batterie nach Anspruch 9, wobei, wenn die ersten Trainingsparameter auf die lokalen SOC-Schätzmodelle angewendet werden, eine Summe von Verlustwerten der lokalen SOC-Schätzmodelle minimiert wird.

11. Vorrichtung (440) zur Abschätzung des Ladezustands (state of charge, SOC) einer Batterie, umfassend:
einen Speicher; und
zumindest einen Prozessor, der elektrisch mit dem Speicher verbunden ist,
wobei der Prozessor dazu ausgebildet ist, ein Meta-Lernen eines globalen SOC-Schätzmodells unter Verwendung erster Trainingsparameter lokaler SOC-Schätzmodelle durchzuführen, die für eine Mehrzahl von Referenzbatterien sind und unter Verwendung von Trainingsdaten für die Mehrzahl von Referenzbatterien trainiert sind, und dazu ausgebildet ist, einen SOC-Wert einer Zielbatterie unter Verwendung des globalen SOC-Schätzmodell, für das das Meta-Lernen durchgeführt wurde, zu bestimmen.

12. Vorrichtung zur SOC-Abschätzung einer Batterie nach Anspruch 11, wobei der Prozessor dazu ausgebildet ist, zweite Trainingsparameter des globalen SOC-Schätzmodells zu bestimmen, und
wenn die zweiten Trainingsparameter auf die lokalen SOC-Schätzmodelle angewendet werden, eine Summe von Verlustwerten der lokalen SOC-Schätzmodelle minimiert wird.

13. Vorrichtung zur SOC-Abschätzung einer Batterie nach Anspruch 11, wobei der Prozessor dazu ausgebildet ist, das globale SOC-Schätzmodell unter Verwendung von Trainingsdaten, die von der Zielbatterie erfasst wurden, zu trainieren, um Meta-Lernparameter des globalen SOC-Schätzmodells zu aktualisieren, und dazu ausgebildet ist, einen SOC-Wert der Zielbatterie unter Verwendung des aktualisierten globalen SOC-Schätzmodells abzuschätzen.

## Revendications

1. Procédé d'estimation de l'état de charge (SOC) d'une batterie comprenant :
la collecte de données d'apprentissage (S110) pour une pluralité de batteries de référence ;
l'exécution d'un méta-apprentissage d'un modèle d'estimation de SOC global (S120) pour estimer une valeur de SOC d'une batterie cible en utilisant des premiers paramètres d'apprentissage de modèles d'estimation de SOC locaux qui sont pour la pluralité de batteries de référence et entraînés en utilisant les données d'apprentissage ; et
l'estimation d'une valeur de SOC de la batterie cible ( S 130) en utilisant le modèle d'estimation de SOC global dont le méta-apprentissage a été effectué.

2. Procédé d'estimation de SOC d'une batterie selon la revendication 3, dans lequel les données d'apprentissage comprennent des tensions, des courants, des températures et des valeurs de SOC mesurées pendant la charge et la décharge de la pluralité de batteries de référence.

3. Procédé d'estimation de SOC d'une batterie selon la revendication 1, dans lequel l'exécution du méta-apprentissage comprend la détermination de seconds paramètres d'apprentissage du modèle d'estimation de SOC global, et
lorsque les seconds paramètres d'apprentissage sont appliqués aux modèles d'estimation de SOC locaux, une somme de valeurs de perte des modèles d'estimation de SOC locaux est minimisée.

4. Procédé d'estimation de SOC d'une batterie selon la revendication 3, dans lequel l'estimation de la valeur de SOC de la batterie cible comprend :
l'apprentissage du modèle d'estimation de SOC global en utilisant des données d'apprentissage pour la batterie cible pour accorder les seconds paramètres d'apprentissage ; et
l'estimation d'une valeur de SOC de la batterie cible en utilisant le modèle d'estimation de SOC global dont les seconds paramètres d'apprentissage ont été accordés.

5. Procédé d'estimation de SOC d'une batterie selon la revendication 4, dans lequel les données d'apprentissage pour la batterie cible sont du même type que des données d'apprentissage pour la pluralité de batteries de référence, et
une quantité des données d'apprentissage pour la batterie cible est inférieure à une quantité des données d'apprentissage pour la pluralité de batteries de référence.

6. Procédé d'estimation de SOC d'une batterie selon la revendication 5, dans lequel la quantité des données d'apprentissage pour la batterie cible est acquise à partir d'une partie d'une plage complète d'un état déchargé de la batterie cible à un état complètement chargé.

7. Procédé d'estimation de SOC d'une batterie selon la revendication 1, dans lequel la batterie cible est une batterie qui diffère au moins en ce qui concerne la structure chimique et la capacité de batterie de la pluralité de batteries de référence.

8. Procédé d'estimation de SOC d'une batterie selon la revendication 1, dans lequel la pluralité de batteries de référence sont des batteries qui diffèrent au moins en ce qui concerne la structure chimique et la capacité de batterie les unes des autres.

9. Procédé d'estimation de l'état de charge (SOC) d'une batterie comprenant :
la réception d'un modèle d'estimation de SOC global (S210) pour estimer une valeur de SOC d'une batterie cible ;
l'apprentissage du modèle d'estimation de SOC global (220) en utilisant des données d'apprentissage pour la batterie cible pour accorder des premiers paramètres d'apprentissage du modèle d'estimation de SOC global ; et
l'estimation d'une valeur de SOC de la batterie cible (S230) en utilisant le modèle d'estimation de SOC global dont les premiers paramètres d'apprentissage ont été accordés,
dans lequel le modèle d'estimation de SOC global est un modèle d'estimation dont un méta-apprentissage a été effectué en utilisant des seconds paramètres d'apprentissage de modèles d'estimation de SOC locaux qui sont pour une pluralité de batteries de référence et entraînés en utilisant des données d'apprentissage pour les batteries de référence.

10. Procédé d'estimation de SOC d'une batterie selon la revendication 9, dans lequel, lorsque les premiers paramètres d'apprentissage sont appliqués aux modèles d'estimation de SOC locaux, une somme de valeurs de perte des modèles d'estimation de SOC locaux est minimisée.

11. Dispositif d'estimation de l'état de charge (SOC) d'une batterie (440) comprenant :
une mémoire ; et
au moins un processeur connecté électriquement à la mémoire,
dans lequel le processeur est configuré pour effectuer un méta-apprentissage d'un modèle d'estimation de SOC global en utilisant des premiers paramètres d'apprentissage de modèles d'estimation de SOC locaux, qui sont pour une pluralité de batteries de référence et entraînés en utilisant des données d'apprentissage pour la pluralité de batteries de référence, et est configuré pour estimer une valeur de SOC d'une batterie cible en utilisant le modèle d'estimation de SOC global dont le méta-apprentissage a été effectué.

12. Dispositif d'estimation de SOC d'une batterie selon la revendication 11, dans lequel le processeur est configuré pour déterminer des seconds paramètres d'apprentissage du modèle d'estimation de SOC global, et
lorsque les seconds paramètres d'apprentissage sont appliqués aux modèles d'estimation de SOC locaux, une somme de valeurs de perte des modèles d'estimation de SOC locaux est minimisée.

13. Dispositif d'estimation de SOC d'une batterie selon la revendication 11, dans lequel le processeur est configuré pour entraîner le modèle d'estimation de SOC global en utilisant des données d'apprentissage acquises à partir de la batterie cible pour mettre à jour des paramètres de méta-apprentissage du modèle d'estimation de SOC global et est configuré pour estimer une valeur de SOC de la batterie cible en utilisant le modèle d'estimation de SOC global mis à jour.
